# EUROPEAN PATENT APPLICATION

(11) **EP 3 078 461 A1**
(43) Date of publication of application: **12.10.2016**
(21) Application number: 14868275.0
(22) Date of filing: 27.11.2014
(51) Int. Cl.: B25J 15/06, B65G 49/07, H01L 21/677

(54) **CONVEYANCE DEVICE**

(30) Priority: 03.12.2013 JP 2013250224
(71) Applicant: Harmotec Co., Ltd., Kofu City Yamanashi 400-0851 (JP)
(72) Inventor: IWASAKA, Hitoshi, Kofu City Yamanashi 400-0851 (JP); TOKUNAGA, Hideyuki, Kofu City Yamanashi 400-0851 (JP); KASAI, Yuji, Kofu City Yamanashi 400-0851 (JP); KOSHIISHI, Katsuhiro, Kofu City Yamanashi 400-0851 (JP)
(74) Representative: Stebbing, Timothy Charles
(86) International application number: PCT/JP2014/081377
(87) International publication number: WO 2015/083609

(57) **Abstract**

Conveyance equipment 10 for conveying a plate-like member includes plural items of liquid discharging equipment that hold the member by discharging liquid to generate a negative pressure between the liquid discharging equipment and the member. Each of the plural items of liquid discharging equipment includes a columnar main body, a flat end face formed at the main body, which faces the member, a concave part formed at the end face, and one or more liquid passages that discharge liquid into the concave part at a peripheral edge of the concave part. The one or more liquid passages are arranged so that a direction in which a liquid flows out of the concave part along the end face and a direction from a center of gravity of the member toward a position of the member, opposite the liquid discharging equipment, form an angle smaller than or equal to 90 degrees.

## Description

### Technical Field

The present invention relates to conveyance equipment.

### Background Art

In recent years, equipment for conveying a plate-like member such as a semiconductor wafer or a glass substrate in a non-contacting manner has been developed. For example, in Patent Document 1, equipment is proposed for conveying a plate-like member in a non-contacting manner, by applying Bernoulli's principle. The equipment includes a cylindrical chamber that opens on the underside of the equipment, into which fluid is supplied to generate a swirl flow. The swirl flow generates a negative pressure in the center, which exerts suction on the plate-like member. On the other hand, a fluid flowing out of the cylindrical chamber causes a given distance to be maintained between the equipment and the plate-like member. Consequently, the equipment conveys the plate-like member in a non-contacting manner. Also in Patent Document 1, use of liquid as fluid is proposed.

### Prior Art Document

### Patent Document

Patent Document 1: JP 2005-51260 A1

### Summary of the Invention

### Problems to be solved by the Invention

It is an object of the present invention to prevent a plate-like member being conveyed by conveyance equipment, which holds the plate-like member by discharging liquid to generate a negative pressure between the conveyance equipment and the plate-like member, from falling off the conveyance equipment under the weight of liquid accumulating on the plate-like member.

### Means for Solving the Problems

The present invention provides conveyance equipment for conveying a plate-like member, comprising: a plate-like base body; and plural items of liquid discharging equipment provided at the base body, that hold the member by discharging liquid to generate a negative pressure between the liquid discharging equipment and the member, wherein each of the plural items of liquid discharging equipment comprises: a columnar main body; a flat end face formed at the main body, that faces the member; a concave part formed at the end face; one or more liquid passages that discharge liquid into the concave part at a peripheral edge of the concave part, wherein: the one or more liquid passages are arranged so that a direction in which a liquid flows out of the concave part along the end face and a direction from a center of gravity of the member toward a position of the member, opposite the liquid discharging equipment form an angle smaller than or equal to 90 degrees; each of the plural items of liquid discharging equipment comprises only one or more liquid passages as a structure for discharging liquid into the concave part at a peripheral edge of the concave part; and the conveyance equipment comprises only the plural items of liquid discharging equipment as a structure for generating a negative pressure between the conveyance equipment and the member.

In the conveyance equipment, two or more items of liquid discharging equipment may be arranged at the base body on a circumference of a circle, and one or more item of liquid discharging equipment may be arranged at the base body at a central part of the circle.

### Effects of the Invention

The present invention prevents a plate-like member being conveyed by conveyance equipment, which holds the plate-like member by discharging liquid to generate a negative pressure between the conveyance equipment and the plate-like member, from falling off the conveyance equipment under the weight of liquid accumulating on the plate-like member

### Brief Description of the Drawings

Fig. 1 is a diagram showing an example of a configuration of conveyance equipment 10.
Fig. 2 is a cross-sectional view of conveyance equipment 10 along the line A-A of Fig. 1.
Fig. 3 is a cross-sectional view of conveyance equipment 10 along the line B-B of Fig. 2.
Fig. 4 is a perspective view of an example of swirl flow-forming body 2.
Fig. 5 is a cross-sectional view of swirl flow-forming body 2 along the line C-C of Fig. 4.
Fig. 6 is a cross-sectional view of swirl flow-forming body 2 along the line D-D of Fig. 4.
Fig. 7 is a diagram showing examples of directions in which a liquid flows out of swirl flow-forming bodies 2 provided at conveyance equipment 10.
Fig. 8 is an enlarged view of part R shown in Fig. 7.
Fig. 9 is a diagram showing an example of a configuration of conveyance equipment 20.
Fig. 10 is a cross-sectional view of conveyance equipment 20 along the line E-E of Fig. 9.
Fig. 11 is a diagram showing an example of a bottom face of conveyance equipment 10A.
Fig. 12 is a cross-sectional view of conveyance equipment 10A along the line F-F of Fig. 11.
Fig. 13 is a perspective view of an example of radial flow-forming body 6.
Fig. 14 is a bottom view of radial flow-forming body 6.
Fig. 15 is a cross-sectional view of radial flow-forming body 6 along the line G-G of Fig. 13.
Fig. 16 is a bottom view of an example of swirl flow-forming body 2A.
Fig. 17 is a cross-sectional view of swirl flow-forming body 2A along the line H-H of Fig. 16.
Fig. 18 is a diagram showing examples of directions in which a liquid flows out of swirl flow-forming bodies 2B provided at conveyance equipment 10B.

### Description of Reference Numerals

1 ··· Base body, 2 ··· Swirl flow-forming body, 3 ··· Friction member, 4 ··· Hole part, 5 ··· Base body, 6 ··· Radial flow-forming body, 10 ··· Conveyance equipment, 11 ··· Supply port, 12 ··· Communication passage, 13 ··· Annular passage, 20 ··· Conveyance equipment, 21 ··· Main body, 22 ··· Concave part, 23 ··· End face, 24 ··· Jetting port, 25 ··· Slope, 26 ··· Introduction port, 27 ··· Annular passage, 28 ··· Communication passage, 29 ··· Introduction passage, 30 ··· Projecting part, 51 ··· Supply port, 52 ··· C-shaped passage, 53 ··· Communication passage, 54 ··· Holding part, 55 ··· Arm part, 61 ··· Main body, 62 ··· Annular concave part, 63 ··· End face, 64 ··· Opposed face, 65 ··· Slope, 66 ··· Nozzle hole, 67 ··· Introduction port, 68 ··· Introduction passage, 69 ··· Annular passage, 70 ··· Communication passage

### Modes for Implementing the Invention

An embodiment of the present invention will be described below with reference to the drawings.

### 1. Embodiment

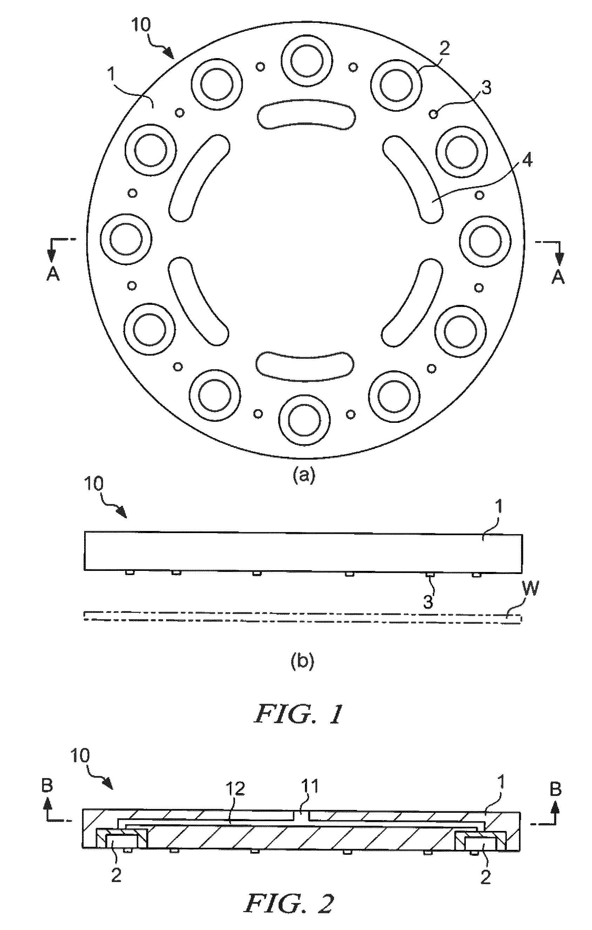

Fig. 1 is a diagram showing an example of a configuration of conveyance equipment 10 according to an embodiment of the present invention. Specifically, Fig. 1(a) is a bottom view of conveyance equipment 10, and Fig. 1(b) is a side view of conveyance equipment 10. Conveyance equipment 10 is equipment for holding and conveying a plate-like member such as a semiconductor wafer or a glass substrate. Conveyance equipment 10 includes base body 1, twelve swirl flow-forming bodies 2, twelve friction members 3, and six hole parts 4, as shown in Fig. 1.

Base body 1 has a disk shape. Base body 1 is made of, for example, an aluminum alloy. Each of twelve swirl flow-forming bodies 2 has a column shape, which is provided at a face of base body 1. The face of base body 1 is, specifically, a face opposite to plate-like member W being conveyed. The face of base body 1 will hereinafter be referred to as "bottom face." Twelve swirl flow-forming bodies 2 are arranged at the bottom face on the circumference of a circle. Twelve swirl flow-forming bodies 2 are arranged at equal intervals along the outer circumference of base body 1. Each of swirl flow-forming bodies 2 is equipment for holding plate-like member W by discharging liquid such as pure water or carbonated water to generate a negative pressure between the swirl flow-forming body and the plate-like member. Each of swirl flow-forming bodies 2 is made of, for example, an aluminum alloy. Each of swirl flow-forming bodies 2 is an example of "liquid discharging equipment" according to the present invention. Conveyance equipment 10 includes only twelve swirl flow-forming bodies 2 as a mechanism for generating a negative pressure between the conveyance equipment and plate-like member W.

Each of twelve friction members 3 has a column shape, which is provided at the bottom face of base body 1. Twelve friction members 3 are arranged at the bottom face at equal intervals on the circumference of the circle, on which swirl flow-forming bodies 2 are arranged. Each of friction members 3 is arranged between two swirl flow-forming bodies 2. Each of friction members 3 is a member for generating a friction force between the friction member and a surface of plate-like member W being conveyed, by coming into contact with the surface of the plate-like member, which friction force prevents the plate-like member from moving. Each of friction members 3 is made of, for example, a fluorine-contained rubber. Six hole parts 4 are through-holes having an elongated shape with rounded ends, which are provided at base body 1. Six hole parts 4 are arranged at base body 1 at equal intervals on the circumference of a circle. The circle on whose circumference hole parts 4 are arranged and the circle on whose circumference swirl flow-forming bodies 2 are arranged are concentric. Hole parts 4 are arranged nearer the center of a surface of base body 1 in relation to swirl flow-forming bodies 2.

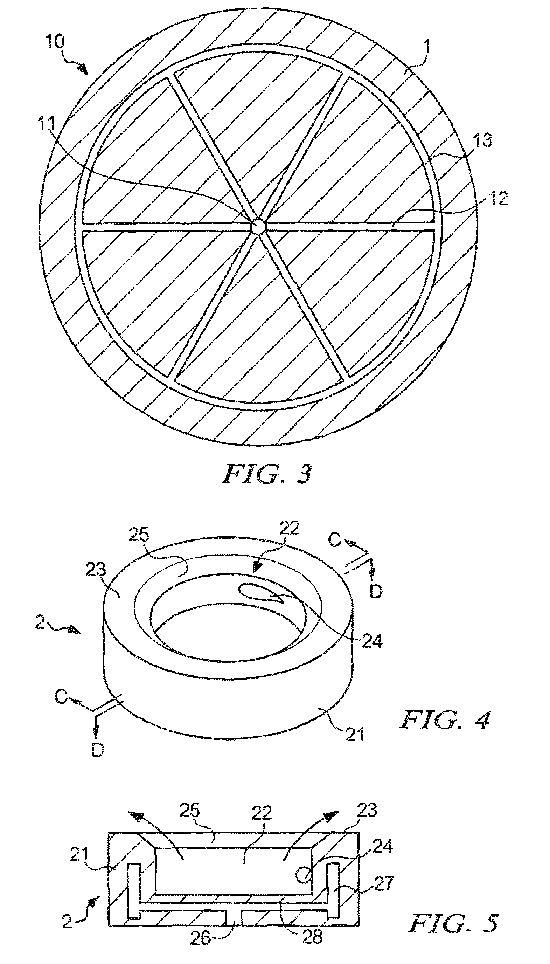

Fig. 2 is a cross-sectional view of conveyance equipment 10 along the line A-A of Fig. 1. Fig. 3 is a cross-sectional view of conveyance equipment 10 along the line B-B of Fig. 2. As shown in Figs. 2 and 3, base body 1 includes supply port 11, three communication passages 12, and annular passage 13. Supply port 11 has a circular shape, which is provided at the center of an upper face (namely, a face opposite to the bottom face) of base body 1. Supply port 11 is connected to a liquid supply apparatus (not shown) via a tube so that supply port 11 supplies liquid into base body 1. Three communication passages 12 are provided inside base body 1, which linearly extend in a radial direction of the bottom or upper face of base body 1. Three communication passages 12 are arranged on the same plane so that adjacent communication passages 12 form an angle of substantially 60 degrees. Both ends of each of communication passages 12 communicate with annular passage 13. Each of communication passages 12 supplies liquid supplied into base body 1 via supply port 11, to annular passage 13. Annular passage 13 is arranged inside base body 1 on the circumference of the circle, on which swirl flow-forming bodies 2 are arranged. Annular passage 13 supplies liquid supplied from communication passage 12, to each of swirl flow-forming bodies 2.

Fig. 4 is a perspective view of an example of swirl flow-forming body 2. As shown in Fig. 4, swirl flow-forming body 2 includes main body 21, concave part 22, end face 23, jetting ports 24, and slope 25. Main body 21 has a column shape. At a face of main body 21, flat end face 23 is formed. The face of main body 21 is, specifically, a face opposite to plate-like member W being conveyed. The face of main body 21 will hereinafter be referred to as "bottom face." Concave part 22 has a column shape, which is provided at end face 23. Concave part 22 is formed so that the concave part and main body 21 are coaxial. Jetting ports 24 are formed at the inner periphery of main body 21, which faces concave part 22. Liquid supplied to swirl flow-forming body 2 is discharged to concave part 22 via jetting ports 24. Slope 25 is formed at the opening edge of concave part 22.

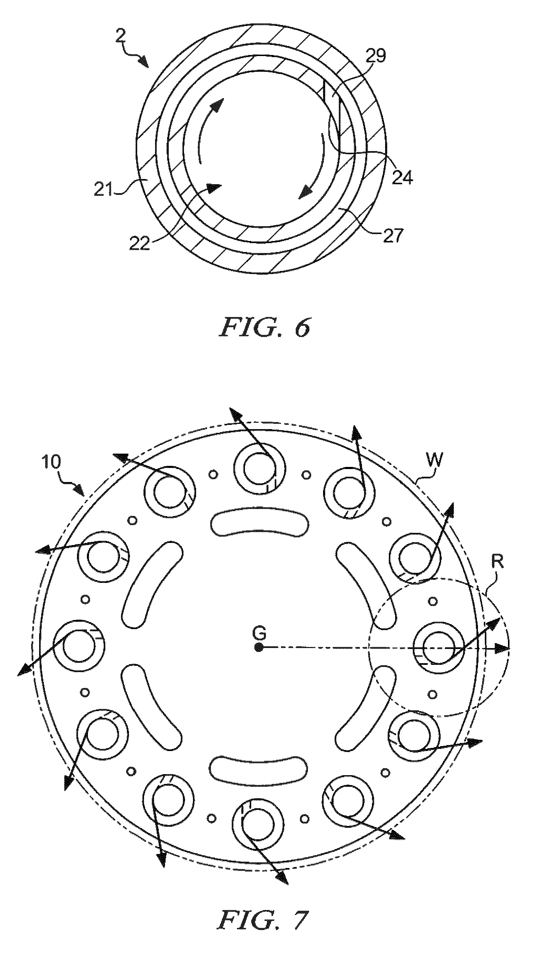

Fig. 5 is a cross-sectional view of swirl flow-forming body 2 along the line C-C of Fig. 4. Fig. 6 is a cross-sectional view of swirl flow-forming body 2 along the line D-D of Fig. 4. As shown in Figs. 5 and 6, swirl flow-forming body 2 further includes introduction port 26, annular passage 27, communication passage 28, and introduction passages 29. Introduction port 26 has a circular shape, which is provided at the center of the upper face (namely, a face opposite to the bottom face) of main body 21. Introduction port 26 communicates with annular passage 13 so that introduction port 26 supplies liquid into main body 21. Annular passage 27 has a cylindrical shape, which is formed inside main body 21 so that the annular passage surrounds concave part 22. Annular passage 27 is formed so that the annular passage and concave part 22 are coaxial. Annular passage 27 supplies liquid supplied from communication passage 28, to introduction passage 29.

Communication passage 28 is provided inside main body 21, and linearly extends in a radial direction of the bottom or upper face of main body 21. Both ends of communication passage 28 communicate with annular passage 27. Communication passage 28 supplies liquid supplied into main body 21 via introduction port 26, to annular passage 27. Introduction passages 29 discharge liquid into concave part 22 via jetting port 24 at the peripheral edge of the concave part. Specifically, introduction passages 29 are formed substantially in parallel with end face 23. Introduction passages 29 are also formed so that they extend in a direction tangential to the outer circumference of concave part 22. One end of introduction passage 29 communicates with annular passage 27, and the other end communicates with jetting port 24. Introduction passages 29 are an example of a "liquid passage" according to the present invention. Swirl flow-forming body 2 includes only introduction passages 29 as a mechanism for discharging liquid into concave part 22 at the peripheral edge of concave part 22.

When liquid is supplied to swirl flow-forming body 2 described in the foregoing via introduction port 26, the liquid passes through communication passage 28, annular passage 27, and introduction passage 29 to be discharged into concave part 22 via jetting port 24. The fluid discharged into concave part 22 forms a swirl flow and is straightened in the concave part, and thereafter flows out from the opening of the concave part. In that situation, if plate-like member W is positioned opposite end face 23, flow of outside fluid (for example, air or water) into concave part 22 is restricted. In addition, since a centrifugal force of the swirl flow develops, and entrainment occurs, fluid molecules per unit volume in the center of the swirl flow become less dense; namely, a negative pressure is generated. As a result, plate-like member W is pushed toward end face 23 by surrounding fluid. On the other hand, as plate-like member W comes close to end face 23, an amount of liquid flowing out of concave part 22 decreases, and a velocity of a liquid discharged into concave part 22 through jetting port 24 decreases, so that a pressure in the center of the swirl flow increases. Accordingly, plate-like member W does not come into contact with end face 23, and a given distance is maintained between the plate-like member and the end face.

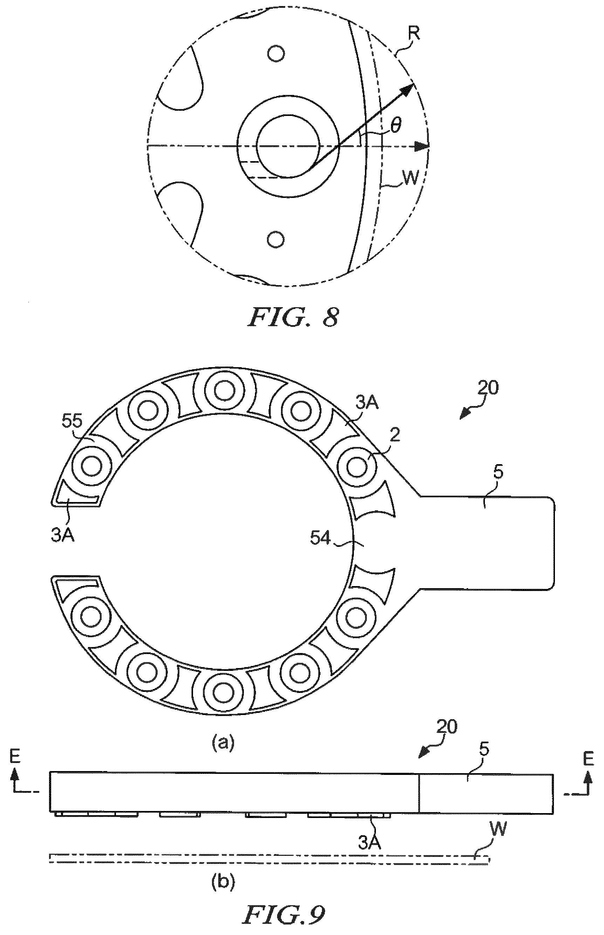

Fig. 7 is a diagram showing examples of directions in which a liquid flows out of swirl flow-forming bodies 2 provided at conveyance equipment 10. Specifically, Fig. 7 is a diagram showing examples of directions in which a liquid flows out of the openings of concave parts 22 of swirl flow-forming bodies 2. Fig. 8 is an enlarged view of part R shown in Fig. 7. In Figs. 7 and 8, a chain line shows introduction passage 29. A solid arrow shows a direction in which a liquid flows out. Two-dot chain arrow is an arrow extending from center of gravity G of plate-like member W in a radial direction, and crossing the central axis of swirl flow-forming body 2 (or the central axis of a swirl flow formed in concave part 22). In Fig. 8, plate-like member W is arranged so that the plate-like member and the circle, on the circumference of which twelve swirl flow-forming bodies 2 are arranged, are concentric.

As shown in Figs. 7 and 8, introduction passage 29 of swirl flow-forming body 2 is arranged so that a direction in which a liquid flows out of concave part 22 along end face 23 and a direction from center of gravity G of plate-like member W toward a position of the plate-like member, opposite the swirl flow-forming body (specifically, a direction passing through center of gravity G of the plate-like member and crossing the central axis of the swirl flow-forming body) form angle θ of substantially 45 degrees. Angle θ is the smaller of the two angles formed by the two directions. In other words, introduction passage 29 of swirl flow-forming body 2 is arranged so a direction in which a liquid flows out of concave part 22 along end face 23 and a direction from the central part of the circle, on the circumference of which twelve swirl flow-forming bodies 2 are arranged, toward the swirl flow-forming body including the introduction passage (specifically, a direction passing through the center of the circle, on the circumference of which twelve swirl flow-forming bodies 2 are arranged, and crossing the central axis of the swirl flow-forming body including the introduction passage) form an angle of substantially 45 degrees. The angle is the smaller of the two angles formed by the two directions.

Since liquid discharged from swirl flow-forming body 2 flows toward the outer edge of plate-like member W, the liquid is easily discharged from the outer edge of the plate-like member. Also, since a flow of liquid toward the outer edge of plate-like member W is formed, liquid discharged to the central part of the plate-like member is easily discharged from the outer edge of the plate-like member. Consequently, liquid is prevented from accumulating on plate-like member W. According to conveyance equipment 10, plate-like member W is prevented from falling off the conveyance equipment under the weight of liquid accumulating on the plate-like member.

It is to be noted that a direction in which a liquid flows out of concave part 22 along end face 23 depends on the diameter and depth of concave part 22, and a velocity of the fluid. In the example shown in Figs. 7 and 8, a liquid flows at an angle of substantially 45 degrees in relation to introduction passage 29. It is also noted that a direction in which a liquid flows out of concave part 22 along end face 23 is, for example, a resultant vector of the fluids flowing out of concave part 22 along end face 23.

### 2. Modifications

The above embodiment may be modified as described below. Two or more of the following modifications may be combined with each other.

### 2-1. Modification 1

Conveyance equipment 10 according to the above embodiment may have another shape. Fig. 9 is a diagram showing an example of a configuration of conveyance equipment 20 according to the present modification. Specifically, Fig. 9(a) is a bottom view of conveyance equipment 20, and Fig. 9(b) is a side view of conveyance equipment 20. Conveyance equipment 20 is equipment for holding and conveying a plate-like member such as a semiconductor wafer or a glass substrate. Conveyance equipment 20 includes base body 5, ten swirl flow-forming bodies 2, and twelve friction members 3A, as shown in Fig. 9.

Base body 5 is a plate-like member in the shape of a two-pronged fork, which includes rectangular holding part 54 and two arm parts 55 that extend forkedly from holding part 54. Base body 5 is made of, for example, an aluminum alloy. Ten swirl flow-forming bodies 2 are provided at a face of two arm parts 55 constituting base body 5. The face of arm parts 55 is, specifically, a face opposite to plate-like member W being conveyed. The face of arm parts 55 will hereinafter be referred to as "bottom face." Ten swirl flow-forming bodies 2 are arranged at two arm parts 55 on the circumference of a circle. Five swirl flow-forming bodies 2 are arranged at each of arm parts 55 at equal intervals.

Twelve friction members 3A are each a plate-like member, which are provided at the bottom face of two arm parts 55. Twelve friction members 3A are arranged at the bottom face on the circumference of the circle, on which swirl flow-forming bodies 2 are arranged. Friction members 3A are arranged at each of arm parts 55 so that two friction members 3A sandwich one swirl flow-forming body 2. Each of friction members 3A is a member for generating a friction force between the friction member and a surface of plate-like member W being conveyed, by coming into contact with the surface of the plate-like member, which friction force prevents the plate-like member from moving. Each of friction members 3 is made of, for example, a fluorine-contained rubber.

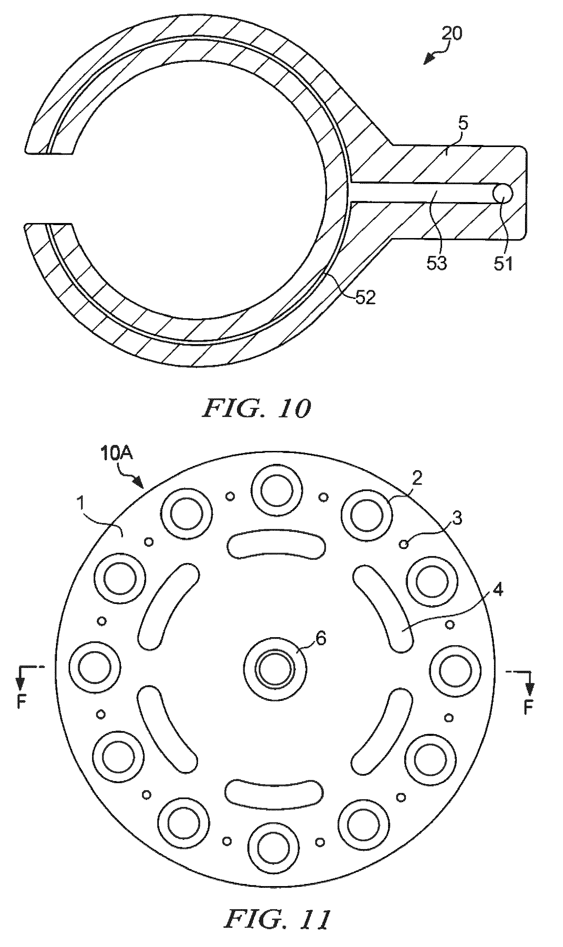

Fig. 10 is a cross-sectional view of conveyance equipment 20 along the line E-E of Fig. 9. As shown in Fig. 10, base body 5 includes supply port 51, C-shaped passage 52, and communication passage 53. Supply port 51 has a circular shape, which is provided at an upper face (namely, a face opposite to the bottom face) of holding part 54. Supply port 51 is connected to a liquid supply apparatus (not shown) via a tube so that the supply port supplies liquid into base body 5. Communication passage 53 is provided inside holding part 54, which linearly extends in the longitudinal direction of the holding part. One end of communication passage 53 communicates with supply port 51, and the other end communicates with C-shaped passage 52. C-shaped passage 52 is provided inside holding part 54 and two arm parts 55. C-shaped passage 52 is arranged on the circumference of the circle, on which swirl flow-forming bodies 2 are arranged. C-shaped passage 52 supplies liquid supplied from communication passage 53, to each of swirl flow-forming bodies 2.

In conveyance equipment 20, introduction passage 29 of swirl flow-forming body 2 is arranged so that a direction in which a liquid flows out of concave part 22 along end face 23 and a direction from the center of gravity of plate-like member W toward a position of the plate-like member, opposite the swirl flow-forming body form an angle of substantially 45 degrees. The angle is the smaller of the two angles formed by the two directions.

### 2-2. Modification 2

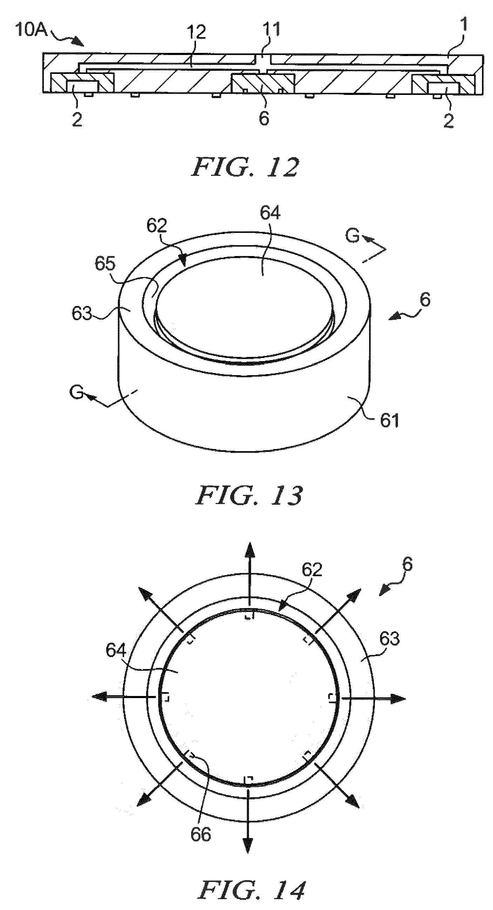

Conveyance equipment 10 according to the above embodiment may be provided with equipment for facilitating discharge of liquid discharged from swirl flow-forming bodies 2 from the outer edge of plate-like member W. Fig. 11 is a diagram showing an example of a bottom face of conveyance equipment 10A according to the present modification. Fig. 12 is a cross-sectional view of conveyance equipment 10A along the line F-F of Fig. 11. As shown in Figs. 11 and 12, conveyance equipment 10A further includes radial flow-forming body 6 as compared to conveyance equipment 10.

Radial flow-forming body 6 is provided at the bottom face of base body 1. Radial flow-forming body 6 is provided at the central part of the circle, on which twelve swirl flow-forming bodies 2 are arranged. Radial flow-forming body 6 is equipment for holding plate-like member W by discharging liquid to generate a negative pressure between the radial flow-forming body and the plate-like member. Radial flow-forming body 6 is also equipment for preventing liquid from accumulating on the center of plate-like member W by radially discharging liquid at the center of the bottom face of base body 1. Liquid is supplied to radial flow-forming body 6 via communication passage 12, as shown in Fig. 12. Radial flow-forming body 6 is an example of "liquid discharging equipment" according to the present invention. Conveyance equipment 10A includes only twelve swirl flow-forming bodies 2 and radial flow-forming body 6 as a mechanism for generating a negative pressure between the conveyance equipment and plate-like member W.

Fig. 13 is a perspective view of an example of radial flow-forming body 6. As shown in Fig. 13, radial flow-forming body 6 includes main body 61, annular concave part 62, end face 63, opposed face 64, and slope 65. Main body 61 has a column shape. At a face of main body 61, flat end face 63 is formed. The face of main body 61 is, specifically, a face opposite to plate-like member W being conveyed. The face of main body 61 will hereinafter be referred to as "bottom face." Annular concave part 62 is formed at end face 63 so that the annular concave part and the outer circumference of main body 61 are concentric. At the bottom face of main body 61, flat opposed face 64 is formed. Opposed face 64 is a face opposite plate-like member W being conveyed, which face is surrounded by annular concave part 62. Opposed face 64 is formed at the bottom face of main body 61 so that it is hollow relative to end face 63. Slope 65 is formed at the opening edge (specifcally, at the outer opening edge) of annular concave part 62.

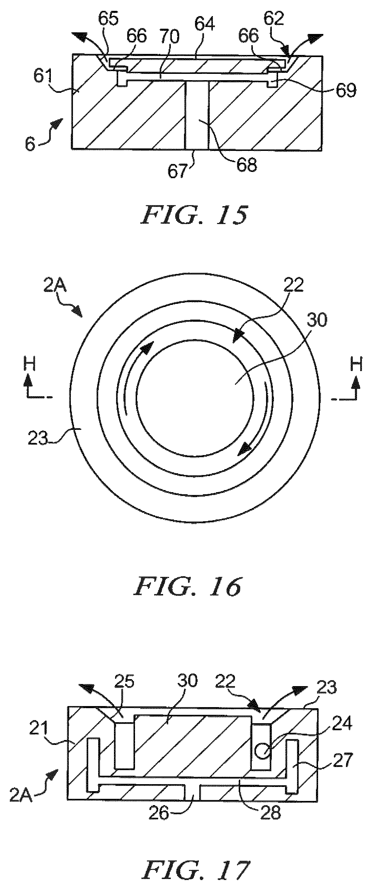

Fig. 14 is a bottom view of radial flow-forming body 6. Fig. 15 is a cross-sectional view of radial flow-forming body 6 along the line G-G of Fig. 13. As shown in Figs. 14 and 15, radial flow-forming body 6 further includes six nozzle holes 66, introduction port 67, introduction passage 68, annular passage 69, and communication passage 70. Introduction port 67 has a circular shape, which is provided at the center of an upper face (namely, a face opposite to the bottom face) of main body 61. Introduction port 67 communicates with introduction passage 68 so that the introduction port supplies liquid into main body 61. Introduction passage 68 is provided inside main body 61, which linearly extends along the central axis of main body 61. One end of introduction passage 68 communicates with introduction port 67, and the other end communicates with communication passage 70. Introduction passage 68 supplies liquid supplied into main body 61 via introduction port 67, to communication passage 70.

Communication passage 70 is provided inside main body 61, which linearly extends in a radial direction of annular passage 69. The central part in an axial direction of communication passage 70 communicates with introduction passage 68, and both ends communicate with annular passage 69. Communication passage 70 supplies liquid supplied from introduction passage 68, to annular passage 69. Annular passage 69 has a cylindrical shape, which is provided inside main body 61. Annular passage 69 is formed so that the annular passage and main body 61 are coaxial. Annular passage 69 supplies liquid supplied from communication passage 70, to nozzle holes 66.

Each of six nozzle holes 66 discharges liquid into annular concave part 62 at the peripheral edge of the annular concave part. Specifically, nozzle holes 66 are formed substantially in parallel with end face 63 or opposed face 64. Nozzle holes 66 are also formed so that they linearly extend in a radial direction of the bottom or upper face of main body 61. One end of nozzle hole 66 communicates with annular passage 69, and the other end communicates with annular concave part 62. Six nozzle holes 66 are formed on the same plane so that adjacent nozzle holes 66 form an angle of substantially 45 degrees. Each of nozzle holes 66 is an example of a "liquid passage" according to the present invention.

When liquid is supplied to radial flow-forming body 6 described in the foregoing, via introduction port 67, the liquid passes through introduction passage 68, communication passage 70, and annular passage 69 to be discharged into annular concave part 62 via nozzle hole 66. The fluid discharged into annular concave part 62 flows out of the opening of the annular concave part. In that situation, if plate-like member W is positioned opposite opposed face 64, flow of outside fluid (for example, air or water) into the space between the opposed face and the plate-like member is restricted. In addition, since entrainment is generated by radial flows, fluid molecules per unit volume in the space become less dense; namely, a negative pressure is generated. As a result, plate-like member W is pushed toward end face 63 by surrounding fluid. On the other hand, as plate-like member W comes close to end face 63, an amount of liquid flowing out of annular concave part 62 decreases, and a velocity of a liquid discharged into through jetting port 24 decreases, so that a pressure in the space increases. Accordingly, plate-like member W does not come into contact with end face 63, and a given distance is maintained between the plate-like member and the end face.

Conveyance equipment 10A described in the foregoing functions further to prevent liquid from accumulating on plate-like member W, by including radial flow-forming body 6 arranged at the center of the bottom face of base body 1, which radially discharges liquid.

It is to be noted that the number (especially, the number of nozzle holes 66), configuration (especially, the configuration of the liquid passages in main body 61), and position of radial flow-forming bodies 6 are not limited to the example shown in the present modification. The parameters may be determined based on the size, shape, and material of plate-like member W to be conveyed by conveyance equipment 10A. Alternatively, swirl flow-forming body 2 may be arranged at the center of the bottom face of base body 1, instead of radial flow-forming body 6. Alternatively, a known non-contacting chuck including an electric fan (see, for example, JP 2011-138948 A1) may be provided. Alternatively, a known swirl flow-forming body including coupled concave parts (see, for example, JP 2007-324382 A1) may be provided. Alternatively, in a case where plate-like member W has a small diameter, base body 1 of conveyance equipment 10 may be provided with only radial flow-forming body 6 or the swirl flow-forming body including coupled concave parts, without having swirl flow-forming bodies 2.

### 2-3. Modification 3

In the above embodiment, swirl flow-forming body 2 may have another shape. Fig. 16 is a bottom view of an example of swirl flow-forming body 2A according to the present modification. Fig. 17 is a cross-sectional view of swirl flow-forming body 2A along the line H-H of Fig. 16. As shown in Figs. 16 and 17, swirl flow-forming body 2A further includes projecting part 30 as compared to swirl flow-forming body 2. Projecting part 30 has a column shape, which is formed so that the projecting part extends from the bottom of concave part 22. Projecting part 30 is also formed so that the projecting part and main body 21 (or concave part 22) are coaxial. The upper face (specifically, a face opposite to plate-like member W being conveyed) of projecting part 30 is formed so that the upper face is hollow relative to end face 23. Between the outer periphery of projecting part 30 and the inner periphery of main body 21, a liquid passage is formed, in which liquid discharged into concave part 22 flows and forms a swirl flow.

It is to be noted that the upper face of projecting part 30 and end face 23 may be on the same plane. The upper face of projecting part 30 may have a chamfered edge.

### 2-4. Modification 4

The configuration (especially, the configuration of liquid passages in base body 1) of base body 1 of conveyance equipment 10 is not limited to the example shown in the above embodiment. The number, shape, and position of friction members 3 and hole parts 4, which are provided at base body 1 of conveyance equipment 10, are not limited to the example shown in the above embodiment. The parameters may be determined based on the size, shape, and material of plate-like member W to be conveyed by conveyance equipment 10. Friction members 3 or hole parts 4 may be omitted from base body 1 of conveyance equipment 10. In a case where friction members 3 are omitted from base body 1 of conveyance equipment 10, plate-like member W conveyed by the conveyance equipment is caused to rotate by flows of liquid discharged from swirl flow-forming bodies 2. A resultant centrifugal force of plate-like member W facilitates discharge of liquid on the plate-like member from the outer edge of the plate-like member. In the case where friction members 3 are omitted from base body 1 of conveyance equipment 10, the base body may be provided with a known centering guide (see, for example, JP 2005-51260 A1) for positioning plate-like member W. Alternatively, in the above embodiment, the bottom face of base body 1 of conveyance equipment 10 may be provided with equipment for sucking liquid accumulating on plate-like member W. The equipment may be arranged, for example, at the central part of the circle, on which twelve swirl flow-forming bodies 2 are arranged.

### 2-5. Modification 5

The number, configuration, and position of swirl flow-forming bodies 2 provided at base body 1 of conveyance equipment 10 are not limited to the example shown in the above embodiment. The parameters may be determined based on the size, shape, and material of plate-like member W to be conveyed by conveyance equipment 10. For example, the number of swirl flow-forming bodies 2 may be smaller or greater than 12. Two or more lines of swirl flow-forming bodies 2 may be arranged along the outer circumference of base body 1. Swirl flows formed in swirl flow-forming bodies 2 may rotate in different directions. Main body 21 of swirl flow-forming body 2 may have a rectangular column shape or an elliptic column shape, instead of a circular column shape. Main body 21 of swirl flow-forming body 2 may be provided with a passage for directly connecting introduction port 26 to introduction passage 29, instead of annular passage 27 and communication passage 28. Slope 25 may be omitted from Main body 21 of swirl flow-forming body 2. In other words, the edge of end face 23 may not be chamfered. One or more of swirl flow-forming bodies 2 may discharge gas such as air.

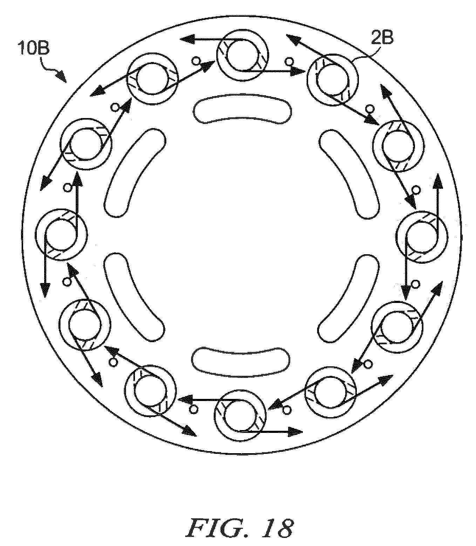

A direction in which a liquid flows out of concave part 22 of swirl flow-forming body 2 along end face 23 and a direction from the center of gravity of plate-like member W toward a position of the plate-like member, opposite the swirl flow-forming body may form an angle other than substantially 45 degrees. The angle may be equal to or smaller than 90 degrees. Similarly, a direction in which a liquid flows out of concave part 22 of swirl flow-forming body 2 along end face 23 and a direction from the central part of the circle, on the circumference of which twelve swirl flow-forming bodies 2 are arranged, toward the swirl flow-forming body including introduction passage 29 may form an angle other than substantially 45 degrees. The angle may be equal to or smaller than 90 degrees. The number of introduction passages 29 provided at swirl flow-forming body 2 is not limited to one. The number may be two or more. Fig. 18 is a diagram showing examples of directions in which a liquid flows out of swirl flow-forming bodies 2B provided at conveyance equipment 10B. Each of swirl flow-forming bodies 2B includes two introduction passages 29. In the example shown in the drawing, a direction in which a liquid flows out of concave part 22 of swirl flow-forming body 2 along end face 23 and a direction from the center of gravity of plate-like member W toward a position of the plate-like member, opposite the swirl flow-forming body form an angle smaller than or equal to 90 degrees. In a case where two or more introduction passages 29 are provided, one or more introduction passages 29 may discharge gas such as air.

### 2-6. Modification 6

In the above embodiment, the bottom face of conveyance equipment 10 may be provided with radial flow-forming bodies 6 described in Modification 2 or known non-contacting chucks including an electric fan (see, for example, JP 2011-138948 A1), instead of swirl flow-forming bodies 2.

## Claims

1. Conveyance equipment for conveying a plate-like member, comprising:
a plate-like base body; and
plural items of liquid discharging equipment provided at the base body, that hold the member by discharging liquid to generate a negative pressure between the liquid discharging equipment and the member, wherein each of the plural items of liquid discharging equipment comprises:
a columnar main body;
a flat end face formed at the main body, that faces the member;
a concave part formed at the end face;
one or more liquid passages that discharge liquid into the concave part at a peripheral edge of the concave part, wherein:
the one or more liquid passages are arranged so that a direction in which a liquid flows out of the concave part along the end face and a direction from a center of gravity of the member toward a position of the member, opposite the liquid discharging equipment form an angle smaller than or equal to 90 degrees;
each of the plural items of liquid discharging equipment comprises only one or more liquid passages as a structure for discharging liquid into the concave part at a peripheral edge of the concave part; and
the conveyance equipment comprises only the plural items of liquid discharging equipment as a structure for generating a negative pressure between the conveyance equipment and the member.

2. The conveyance equipment according to Claim 1, wherein:
two or more items of liquid discharging equipment are arranged at the base body on a circumference of a circle; and
one or more item of liquid discharging equipment is arranged at the base body at a central part of the circle.
